# FASCICULE DE BREVET EUROPEEN

(11) **EP 3 264 480 B1**
(45) Date de publication et mention de la délivrance du brevet: **22.05.2019**
(21) Numéro de dépôt: 17176516.7
(22) Date de dépôt: 18.06.2017
(51) Int. Cl.: H01L 41/09

(54) **ACTIONNEUR ÉLECTROMÉCANIQUE**
ELEKTROMECHANISCHES STELLGLIED
ELECTROMECHANICAL ACTUATOR

(30) Priorité: 17.06.2016 FR 1655649
(43) Date de publication de la demande: 03.01.2018
(73) Titulaire: Commissariat à l'Energie Atomique et aux Energies Alternatives, 75015 Paris (FR)
(72) Inventeur: ABERGEL, Julie, 38000 GRENOBLE (FR); DANEL, Jean-Sébastien, 38130 ECHIROLLES (FR); DEFAY, Emmanuel, 38100 GRENOBLE (FR); LE RHUN, Gwenaël, 38140 RENAGE (FR)
(74) Mandataire: Decobert, Jean-Pascal

(56) Documents cités:
- BE-A6- 1 003 565
- US-A- 4 638 205
- KOBAYASHI T ET AL: "Development of Self-Sensitive Piezoelectric Cantilever Utilizing PZT Thin Film Deposited on SOI Wafer", INTEGRATED FERROELECTRICS, vol. 89, 2007, pages 116-122, XP055353532, ISSN: 1058-4587, DOI: 10.1080/10584580601077641
- WAKATSUKI N ET AL: "Piezoelectric Actuator of LiNbO3 with an Integrated Displacement Sensor", JAPANESE JOURNAL OF APPLIED PHYSICS, vol. 37, no. 5B, mai 1998 (1998-05), pages 2970-2973, XP055355193, ISSN: 0021-4922

## Description

### DOMAINE DE L'INVENTION

La présente invention concerne en général la réalisation de composants microélectroniques. Il pourra s'agir d'actionneurs électromécaniques, plus particulièrement sous forme de MEMS et/ou NEMS (de l'anglais « micro ou nano electro mechanical systems »). Des applications indicatives sont les micro-pompes et les micro-interrupteurs. L'invention sera particulièrement appropriée pour les actionneurs analogiques ou les actionneurs soumis à des perturbations extérieures (dont variations de température, de pression, vieillissement des pièces).

### ARRIERE-PLAN TECHNOLOGIQUE

La microélectronique connaît une forte diversification de composants souvent destinés à être utilisés dans des dispositifs plus complexes. Certains de ces composants impliquent une déformation d'une partie mobile sous la commande d'un signal électrique pour former un actionneur. Dans certains cas, un capteur de déformation y est présent pour évaluer le niveau de déformation obtenu par la commande électrique, avantageusement en temps réel. Cette évaluation peut permettre un rétrocontrôle de la commande de l'actionneur, par exemple pour atteindre finement un niveau de déformation souhaité.

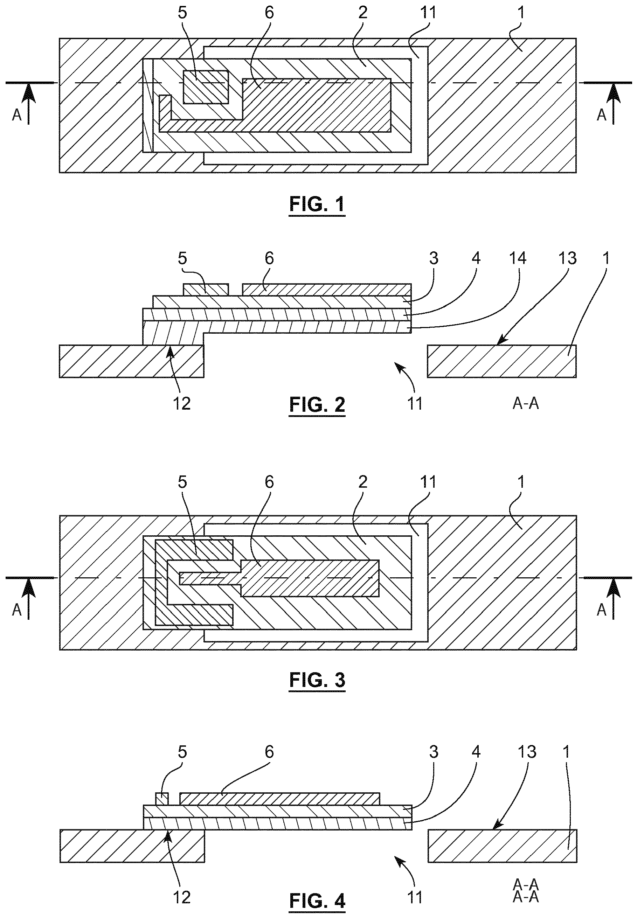

Il existe des techniques, décrites dans la publication EP2309559 A1**,** pour incorporer une jauge de mesure de déformation dans un actionneur. La structure qui y est présentée, notamment en figure 1, associe un actionneur piézoélectrique à une jauge piézorésistive reliée à un dispositif de mesure de résistance. Sous l'effet d'une tension appliquée aux bornes de la couche piézoélectrique, la structure se défléchit déformant ainsi la jauge piézorésistive. La résistance de la jauge est alors modifiée, ce qui permet d'évaluer la déformation de la structure. Ce dispositif présente cependant plusieurs inconvénients :
- la détection piézorésistive entraîne une dissipation d'énergie par effet Joule, induisant d'une part une surconsommation énergétique et d'autre part un échauffement du dispositif susceptible de modifier les propriétés piézoélectriques de la couche voire de dégrader la structure.
- En cas perturbation extérieure (par exemple une variation de température), le capteur et l'actionneur ne sont pas impactés de la même manière, ce qui induira une erreur de mesure.
- De plus, la sensibilité du capteur décroît lorsque la largeur de la jauge croît, ce qui impose de réaliser des jauges fines et donc plus difficiles à réaliser (en couches minces, ces limitations peuvent être dues à la résolution de lithographie).

La publication KOBAYASHI et al intitulée « Development of Self-Sensitive Piezoelectric Cantilever Utilizing PZT Thin Film Depositied on SOI Wafer » issue de INTEGRATED FERROELECTRICS, Vol. 89, 2007, pages 116-122, divulgue un actionneur comportant un empilement avec deux électrodes et une couche piezoélectrique intercalée. Il comprend aussi un capteur de déformation avec une électrode de capteur qui mesure un signal de la tension à ce niveau, en rapport avec la fréquence du signal d'entrée de l'actionneur. Cette information de fréquence de signal de tension est ensuite exploitée. Même si l'électrode de mesure est individualisée et séparée de celle servant à d'actionnement, il s'agit ici encore d'une mesure en tension issue d'un comportement vibratoire et piezoélectrique d'un empilement de couches.

Une technique équivalente est présentée dans la publication WAKATSUKI N et al intitulée «Piezoelectric Actuator of LiNbO3 with an Integrated Displacement Sensor » issue de JAPANESE JOURNAL OF APPLIED PHYSICS, Vol.37, no.5B, 1998, pages 2970-2973.

Des inconvénients de la détection fréquentielle des techniques actuelles sont:
- que les mesures sont difficiles (car l'instrumentation est lourde), peu précises ; il a des problématiques d'amortissement lié à l'atmosphère pouvant introduire une incertitude de mesure. Par ailleurs un actionneur n'a pas en général besoin d'être actionné à sa fréquence de résonance pour sa mobilité en tant que telle, mais c'est ce qui est imposé par la méthode de détection fréquentielle et qui peut notamment accélérer le vieillissement du composant.
- que les matériaux d'actionneurs les plus efficaces comme le PZT sont souvent de mauvais résonateurs et réciproquement (AIN bon résonateur et moins bon actionneur), ce qui oblige à des choix pénalisant soit la mobilité, soit la mesure.

C'est donc un objet de l'invention que de pallier au moins en partie les inconvénients des techniques actuelles en offrant un actionneur dans lequel une mesure de déformation peut être opérée de manière améliorée.

### RESUME DE L'INVENTION

Un aspect de la présente invention concerne un actionneur électromécanique comportant un support et un élément déformable comprenant une partie ancrée à au moins une zone d'ancrage du support et une partie mobile, l'élément déformable comprenant une couche électro-active, une électrode de référence disposée sur une première face de la couche électro-active et une électrode d'actionnement disposée sur une deuxième face, opposée à la première face de la couche électro-active, la couche électro-active étant configurée pour se déformer sous l'effet d'une différence de potentiel appliquée entre l'électrode de référence et l'électrode d'actionnement, et un dispositif capacitif de mesure de déformation de l'élément déformable, ledit dispositif étant au moins en partie formé par un empilement capacitif comprenant une électrode de mesure disposée sur la deuxième face de la couche électro-active, une partie de mesure de l'électrode de référence située en regard de l'électrode de mesure, et une partie de la couche électro-active intercalée entre l'électrode de mesure et la partie de mesure de l'électrode de référence, selon la revendication indépendante 1.

Ainsi, on tire parti d'un actionnement par une couche électro-active -qui peut être par exemple piézoélectrique- tout en disposant d'une évaluation de déformation de type capacitive, la nature de la valeur mesurée par le dispositif capacitif étant une capacité de l'empilement capacitif. Cette valeur de capacité peut servir à déterminer la déformation. L'invention associe alors des techniques a priori fort hétérogènes mais cette combinaison permet une grande efficacité en actionnement et en détection. En outre, la détection capacitive est judicieusement incorporée dans l'actionneur pour simplifier la fabrication. En particulier, la couche électro-active de l'actionneur participe à l'empilement capacitif.

Alors que les techniques actuelles de mesure sont de nature similaire à celle d'actionnement, en exploitant des effets électriques de couches piézoélectriques, en particulier en mesurant des variations de fréquences de signaux de tension issus de couches piézoélectriques, la présente invention a l'avantage d'opérer une mesure de capacité et de permettre d'en suivre la variation. Cela combat un préjugé constant quant à l'exploitation du comportement mécanique d'un élément piézoélectrique. C'est, de manière avantageuse, la valeur de capacité d'un empilement qui est mesurée directement entre l'électrode de mesure et la partie de mesure de l'électrode de référence.

La mesure capacitive de l'invention est potentiellement moins lourde à mettre en oeuvre et est d'une bonne précision, sans que cette précision varie selon les matériaux électro actifs dans des proportions telles que connues pour les techniques fréquentielles actuelles. Alors même que la mesure capacitive aurait pu paraitre comme contre nature dans le contexte d'un actionneur avec une couche électro active dans l'empilement dont la capacité est mesurée, cette solution est, au final, avantageuse.

### BREVE INTRODUCTION DES FIGURES

D'autres caractéristiques, buts et avantages de la présente invention apparaîtront à la lecture de la description détaillée qui suit, en regard des dessins annexés, donnés à titre d'exemples, non limitatifs, et sur lesquels :
- La FIGURE 1 illustre en vue de dessus d'un premier mode de réalisation d'un actionneur utilisable selon l'invention.
- La FIGURE 2 montre l'actionneur de la figure 1 en coupe suivant les lignes AA de la figure 1.
- La FIGURE 3 est une vue de dessus un deuxième mode de réalisation d'un actionneur utilisable selon l'invention.
- La FIGURE 4 est une vue de l'actionneur de la figure 3 en coupe suivant les lignes AA de la figure 3.
- La FIGURE 5 est une vue de dessus selon un troisième mode de réalisation d'un actionneur utilisable selon l'invention.
- La FIGURE 6 est une vue de l'actionneur de la figure 5 en coupe suivant les lignes AA de la figure 5.
- La FIGURE 7 est une vue de dessus selon un quatrième mode de réalisation d'un actionneur utilisable selon l'invention.
- La FIGURE 8 illustre l'actionneur de la figure 7 en coupe suivant les lignes AA de la figure 7.
- La FIGURE 9 illustre de dessus un cinquième mode de réalisation d'un actionneur utilisable selon l'invention.
- La FIGURE 10 illustre l'actionneur de la figure 9 en coupe suivant les lignes AA de la figure 9.
- Les FIGURES 11a, 11b, 12a, 12b, 13a, 13b, 14a, 14b, 15a et 15b illustrent des étapes d'un procédé de fabrication d'un actionneur.
- Les FIGURES 16a et 16b présentent respectivement de dessus et en coupe le raccordement des composants électriques à différentes parties de l'actionneur.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et substrats peuvent ne pas être représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- l'empilement capacitif est situé à proximité de la zone d'ancrage 12 ;
- l'empilement capacitif est situé pour partie dans la partie ancrée et pour partie dans la partie flexible ;
- au moins une portion de l'empilement capacitif est située dans une zone de l'élément déformable 2 présentant un pic de concentration de contraintes en flexion ;
- la partie mobile comprend une poutre ou une membrane de profil circulaire, rectangulaire ou polygonale ;
- au moins une portion de l'électrode de mesure présente un profil parallèle au profil de la partie mobile ;
- au moins une portion de l'électrode de mesure présente un profil arqué et au moins une portion de la partie mobile présente un profil circulaire, lesdits profils étant de préférence parallèles.
- le dispositif de mesure comprend un empilement capacitif secondaire comprenant une électrode secondaire de mesure 7 disposée sur la deuxième face de la couche électro-active 3, une partie secondaire de mesure de l'électrode de référence 4 située en regard de l'électrode secondaire de mesure 7, et une partie de la couche électro-active 3 intercalée entre l'électrode secondaire de mesure 7 et ladite partie secondaire de mesure de l'électrode de référence 4 ;
- au moins une portion de l'électrode secondaire de mesure 7 présente un profil parallèle au profil de la partie mobile ;
- le profil de la portion de l'électrode secondaire de mesure 7 est situé à mi-rayon du profil circulaire de la membrane ;
- une portion de l'empilement capacitif secondaire est située dans une zone de l'élément déformable 2 présentant un minimum de concentration de contraintes ;
- au moins une portion de l'empilement capacitif secondaire est située dans une zone de l'élément déformable 2 présentant une contrainte de signe opposée à celle de la zone dans laquelle est située au moins une portion de l'empilement capacitif ;
- un dispositif de traitement différentiel des variations de valeur de capacité de l'empilement capacitif et de l'empilement capacitif secondaire ;
- une source de tension S raccordée, par une première de ses bornes, à l'électrode d'actionnement 6, un capacimètre C raccordé, par une première de ses bornes, à l'électrode de mesure 5, les deuxièmes bornes de la source de tension et du capacimètre étant toutes deux raccordées à l'électrode de référence 4 et au potentiel de référence ;
- la couche électro-active 3 comprend au moins une couche d'un matériau choisi parmi : un matériau piézoélectrique, un matériau électro-strictif, un matériau para-électrique ou un matériau relaxeur ;
- l'électrode de mesure 5 et l'électrode d'actionnement 6 sont des portions gravées d'une même couche de matériau.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Des expressions du type « au regard de » s'entendent comme d'une disposition d'un premier élément relativement à un deuxième, dans laquelle les deux éléments sont en vis-à-vis autour d'une partie intermédiaire, telle une couche électro-active. Préférentiellement, la projection d'un élément suivant une direction en épaisseur des couches intersecte l'autre élément.

Il est précisé que, dans le cadre de la présente invention, l'épaisseur d'une couche se mesure selon une direction perpendiculaire à la surface selon laquelle cette couche présente son extension maximale.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement. En particulier, on verra que plusieurs électrodes de mesure peuvent être présentes dans l'invention.

Selon l'invention, on entend par dispositif microélectronique, un dispositif comportant des éléments de dimensions micrométriques et/ou nanométriques.

Il en va de même du terme « composant électronique » éventuellement ici employé. Tout système ayant pour son fonctionnement au moins un élément électrique entre dans le cadre de l'invention. Ce dispositif microélectronique peut être un MEMS ayant par exemple une fonction mécanique et/ou optique et/ou photonique et/ou électrique.

Les dessins, et la description qui suit, se concentrent par simplicité sur la formation d'un seul composant actionneur mais il est entendu que plusieurs actionneurs peuvent être fabriqués simultanément ou successivement sur un même support ou substrat, par exemple par préhension et placement d'une pluralité de deuxièmes substrats, par une technique telle que le flip chip (report par accostage de puces).

La **figure 1** présente une vue de dessus d'un premier mode de réalisation d'un actionneur utilisable selon l'invention avec un support 1 servant de base à la réception d'un système actionneur. Le support 1 peut être en différents matériaux et par exemple en un matériau semi-conducteur à base de silicium. Le support 1 reçoit un élément déformable 2 ici de forme sensiblement allongée aplatie, sous forme de lame ou de poutre. L'élément déformable 2 comprend une partie solidaire d'une des faces 13 du support 1, au niveau d'une zone d'ancrage 12 dudit support 1. La partie ancrée est destinée à ne pas subir de déformation entraînant un mouvement suivant la direction de déformation de l'élément déformable 2. Dans le cas représenté aux différentes figures mais non limitatif, l'élément déformable 2 présente une capacité de flexion relativement au support 1 en dehors de la partie ancrée.

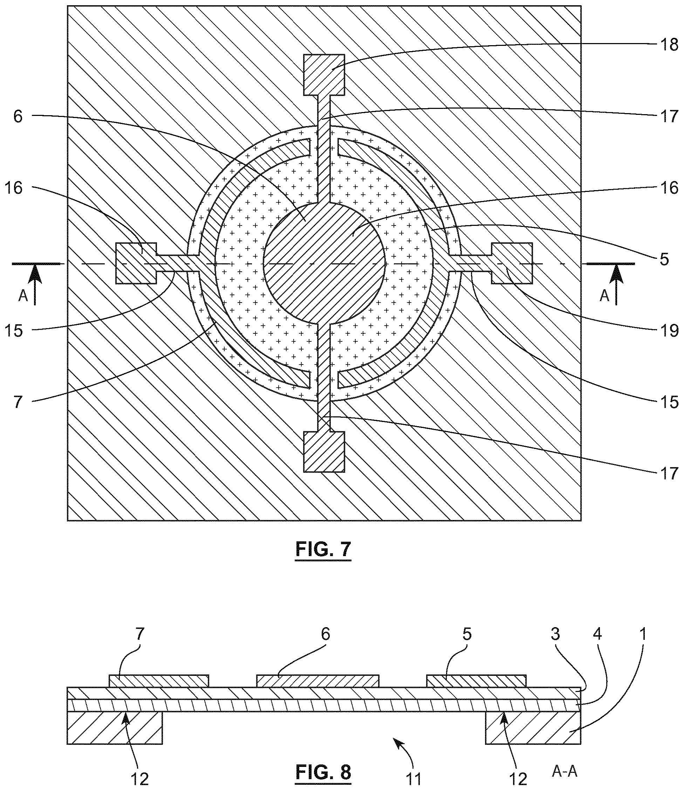

Dans le cas des figures 1 à 6, la zone d'ancrage 12 du support 1 est une portion unique d'une face 13 du support. Cette solution n'est pas limitative. En particulier, comme on le verra en référence aux figures 7 à 10 notamment, la zone d'ancrage peut être répartie en plusieurs zones de la face 13 du support. Il peut même s'agir d'une surface continue tel un contour fermé comme celui représenté aux figures 7 à 10.

À l'inverse de la partie ancrée de l'élément déformable 2, une autre partie est destinée à subir un mouvement par déformation, de préférence totalement élastique, d'une portion de l'élément déformable 1. Cette partie correspond à une partie mobile qui n'est pas retenue dans un mouvement par exemple vis-à-vis du support 1. Ce mouvement issu d'une déformation peut être en flexion suivant un ou plusieurs axes e/ou en traction et/ou en compression et/ou en torsion selon un ou plusieurs axes. Ce mouvement peut donc être de nature différente et/ou être complexe. Dans l'exemple qui suit, la partie mobile qui est sujette à ce mouvement est mobile en flexion, dite partie flexible, suivant une direction, mais ce n'est qu'indicatif. D'une manière générale, le support 1 est configuré pour immobiliser la zone d'ancrage sans immobiliser la partie mobile, suivant le mouvement souhaité.

En particulier, aux différentes figures, le support 1 comporte une cavité 11 en regard de la partie flexible de l'élément déformable 2 au sein de laquelle la partie mobile, flexible ici, peut se débattre. De plus, dans le cas des figures 1 et 2, la partie flexible est en élévation relativement au support 1 de sorte qu'une liberté de mouvement relative est permise suivant le sens de la hauteur du support. Dans le cas de ces deux figures, l'actionneur comprend une poutre 14 par exemple en SiN dont une portion est en contact avec la face 13 du support 1 de sorte à former la partie ancrée et dont une portion est en élévation relativement au support 1 de sorte à préserver un espace entre la face 13 et la surface inférieure de cette portion, de sorte à autoriser une déformation en flexion à ce niveau.

Dans le cas des autres modes de réalisation illustrés, le support 1 comporte une cavité 11 suffisante pour autoriser le débattement de la partie flexible de l'élément déformable 2. Dans les cas représentés, la cavité 11 est débouchante au niveau des deux faces opposées du support 1. Cependant, cette disposition n'est pas limitative et une cavité sous forme d'un trou borgne dont l'embouchure est uniquement au niveau de la face 13 du support 1 peut suffire.

De préférence, la déformation en flexion s'opère suivant une direction de rotation parallèle à un plan de la face 13 du support 1. D'une manière générale, il est souhaitable que la partie flexible, et de préférence l'ensemble de l'élément déformable 2, s'étende parallèlement au support 1.

La **figure 2** est une vue en coupe suivant les lignes A-A de la figure 1. Cette figure permet d'appréhender d'une part la réalisation en élévation de l'élément déformable et d'autre part l'enchaînement des différentes couches servant à constituer l'élément déformable 2. On notera successivement la présence, à partir du support 1, de la poutre 14, d'une électrode de référence 4, d'une couche électro-active 3 et d'une partie supérieure comprenant une ou plusieurs électrodes de mesure 5 et une ou plusieurs électrodes d'actionnement 6.

On entend par couche électro-active une couche faite d'au moins une sous-couche d'un matériau dont la constante diélectrique varie avec la contrainte mécanique. Ainsi, on emploiera si possible des matériaux qui présentent des variations de permittivité importantes. On peut par exemple utiliser des matériaux paraélectriques dont la variation de permittivité peut atteindre notamment 2,7.10⁻² %/MPa. Suivant une autre possibilité, la couche électro-active est faite au moins en partie d'un matériau piézoélectrique, tel du zirconate de plomb et de titane, du nitrure d'aluminium ou de l'oxyde de zinc, du LiNbO3. On peut aussi citer d'autres matériaux électroactifs: KNaNbO3, LiTaO3, PMN-PT (Pb(Mg,Nb)O3 - PbTiO3), polymères (PVDF), PZT dopés (La, Nb, Mn,...) et AIN dopé (Sc). On peut également utiliser des matériaux relaxeurs. On pourra par ailleurs choisir des matériaux qui possèdent un coefficient électrostrictif élevé permettant d'obtenir un capteur à sensibilité élevée.

De préférence mais non exclusivement, l'épaisseur de la couche électro-active est comprise entre 0.1 µm et 0.2 µm.

L'électrode de référence 4 est disposée au contact d'une première face, encore appelée face inférieure, de la couche électro-active 3. Elle est en outre au-dessus de la face 13 du support 1. L'épaisseur de cette couche est avantageusement inférieure ou égale à celle de la couche électro-active 3. Par ailleurs, la fonction de l'électrode 4 est de servir de conducteur électrique sur une des faces de la couche électro-active 3. En ce sens, on pourra utiliser des matériaux habituellement employés pour constituer des électrodes en microélectronique. Il peut par exemple s'agir de platine ou de tungstène ou encore d'aluminium, de cuivre, d'argent, de nickel, de chrome, ou encore d'alliages de ce type de métaux. Avantageusement, l'électrode de référence 4 couvre la totalité de la face inférieure de la couche électro-active 3.

Au niveau d'une face opposée de la couche électro-active 3, d'autres électrodes sont formées. Cette partie comprend au moins une électrode d'actionnement 6 permettant, en conjonction avec l'électrode de référence 4, ces deux électrodes étant en regard, d'appliquer une différence de potentiel électrique entre les deux faces de la couche électro-active de sorte à la commander en déformation. On pourra utiliser les mêmes matériaux que ceux indiqués pour la couche de l'électrode de référence 4 en ce qui concerne l'électrode d'actionnement 6.

Dans le cas du mode de réalisation des figures 1 et 2, l'électrode d'actionnement 6 s'étend depuis la partie ancrée vers la partie flexible, de préférence avec une direction longitudinale correspondant à celle de la partie flexible. D'autre part, l'électrode 6 peut être disposée au niveau de l'axe longitudinal de la partie flexible.

Au niveau de cette même face de la couche électro-active 3 au contact de l'électrode 6, au moins une électrode de mesure 5 est également présente. Ainsi, l'électrode d'actionnement 6 ne couvre avantageusement pas toute la surface de la couche électro-active 3 en regard de l'électrode de référence 4. De cette façon, une surface résiduelle est ménagée pour la réception d'au moins une électrode de mesure 5. Celle-ci s'étend au moins en partie sur une zone de la surface de la couche électro-active 3 au niveau de laquelle une déformation est produite, à savoir dans la partie flexible. Cela n'empêche pas que l'électrode de mesure 5 peut également recouvrir en partie la partie ancrée de l'élément déformable 2. C'est le cas représenté aux figures 1 et 2 au niveau desquelles une électrode de mesure 5 s'étend depuis la partie ancrée vers la partie flexible en surplomb de la cavité 11, au niveau d'une portion de poutre de l'élément déformable 2 en élévation relativement au support par une forme de potence.

Les matériaux et dimension en épaisseur possibles pour l'électrode de mesure 5 peuvent être choisies conformes aux exemples donnés pour l'électrode d'actionnement 6. Elles sont d'ailleurs de préférence issues d'une même couche de matériau. L'électrode de mesure 5 s'étend cependant avantageusement sur une surface moindre de la face de la couche électro-active 3 de sorte à localiser une mesure de déformation 2 de l'élément déformable. À ce sujet, l'électrode de mesure 5, la portion de la couche électro-active 3 sous-jacente et la partie, dite partie de mesure, de l'électrode de référence 4 située en regard de l'électrode de mesure 5 forment un empilement capacitif permettant une détection capacitive d'un niveau de déformation. Dans l'exemple des figures 1 et 2, l'électrode de mesure 5 est de contour rectangulaire.

Avantageusement, il est intéressant de placer cet empilement capacitif de sorte à couvrir une zone de forte contrainte mécanique lors de la flexion de la partie flexible. Ainsi, on privilégiera une localisation de cet empilement à une zone de concentration de contraintes. Typiquement, pour un actionneur tel que dans les modes de réalisation représentés aux figures 1 à 6, dans lequel l'élément déformable est essentiellement sous forme d'une lame, il sera avantageux qu'au moins une partie de l'empilement capacitif soit située à proximité de la zone d'ancrage 12 relativement au support 1. C'est le sens des exemples des figures 1 à 6 dans lesquels l'électrode 5 est localisée de sorte à ce que l'empilement capacitif soit situé à cheval sur la zone d'ancrage 12 et sur une zone de la partie flexible de l'élément déformable 2 à proximité de la zone d'ancrage 12.

La **figure 3** est une vue de dessus d'une variante des figures 1 et 2 dans laquelle l'élément déformable 2 est directement au contact du support 1 dans la partie ancrée, sans recours à un élément de poutre supplémentaire. En l'espèce, la partie flexible de l'élément déformable se situe en surplomb d'une cavité 11 formant un volume autorisant la liberté de mouvement de cette partie flexible. Par ailleurs, ce mode de réalisation montre un aspect différent de forme d'électrode de mesure 5. Celle-ci a un contour en U avec une branche de base, ici située au niveau de la zone d'ancrage 12, perpendiculaire à la direction longitudinale de l'élément déformable 2, et deux branches latérales perpendiculaires à la branche de base et s'étendant sur la partie flexible. Par ailleurs, dans cet exemple, les deux branches latérales de l'électrode de mesure 5 se situent de part et d'autre d'une portion de l'électrode d'actionnement 6. Avantageusement, le profil en U de l'électrode 5 est symétrique suivant la direction longitudinale de l'élément déformable 2.

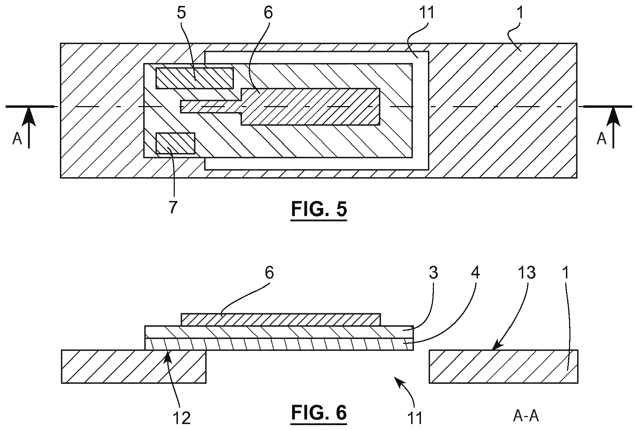

La **figure 5** est une vue de dessus d'un troisième mode de réalisation dans lequel l'électrode 6 est similaire à celle présentée dans l'exemple des figures 3 et 4, et avec une électrode de mesure 5 de forme rectangulaire à cheval sur la zone d'ancrage 12 et la zone de l'élément déformable de en surplomb au-dessus de la cavité 11. En outre, ce mode de réalisation présente une électrode secondaire de mesure 7. De façon semblable à l'empilement capacitif formé à partir de l'électrode de mesure 5, d'une portion sous-jacente de l'électrode active 3 et d'une portion en regard de l'électrode de référence 4, l'électrode secondaire 7 permet la formation d'un empilement capacitif avec une portion sous-jacente de la couche électro-active 3 et une portion, dite partie de mesure secondaire, de l'électrode de référence 4 située en regard de l'électrode secondaire de mesure 7. Dans le cas représenté aux figures 5 et 6, l'électrode 7 est placée de sorte à former un empilement capacitif secondaire situé au niveau de la zone d'ancrage 12 du support 1. De la sorte, les contraintes qui sont appliquées sont faibles, voire nulles. Cette solution peut être mise en oeuvre pour une mesure différentielle. On tire ainsi bénéfice de la présence de deux empilements capacitifs présentant chacun, au repos, une même contrainte mécanique et une même valeur de permittivité. Par contre, en situation d'actionnement, chacun de ses empilements capacitifs sera soumis à une contrainte mécanique différente et une variation de valeurs de permittivité différente. En opérant une mesure différentielle de ces permittivités, on peut évaluer la déformation de la structure de manière moins sensible aux perturbations extérieures. Dans ce cadre, tel que dans l'exemple des figures 5 et 6, l'empilement capacitif secondaire formé à partir de l'électrode secondaire de mesure constitue une référence qui peut être placée notamment sur une partie fixe de la structure.

La **figure 7** illustre, en combinaison avec la figure 8, un autre mode de réalisation dans lequel la partie flexible est formée à partir d'une membrane. Comme précédemment, celle-ci s'étend au-dessus d'une cavité 11 formée dans le support 1. De manière préférée, l'ensemble du contour de la membrane est ancré relativement au support, au niveau du contour de la cavité 11. De manière préférée, le contour de la membrane formant la partie flexible est circulaire, notamment lorsque le profil de la partie mobile est circulaire, l'électrode de mesure présente avantageusement un profil arqué.

Dans un premier cas correspondant aux modes de réalisation des figures 7 et 8, on a formé un premier empilement capacitif au niveau de l'électrode de mesure 5. Par ailleurs, on a formé un deuxième empilement capacitif au niveau de l'électrode secondaire de mesure 7. Dans l'exemple représenté, une symétrie centrale de l'actionneur est produite, au niveau du centre de la membrane qui est circulaire. À titre préféré, au moins une partie d'une des électrodes 5, 7 présente un profil arqué s'étendant sur la membrane de manière concentrique avec celle-ci. Dans le cas de la figure 7, les deux électrodes 5,7 sont formées de part et d'autre d'un diamètre de la membrane de manière symétrique et présentent des mêmes formes et diamètre. Elles sont situées à un même niveau de rayon du contour circulaire de la membrane. On comprend que ces parties forment des portions arquées avantageusement en arc de cercle au niveau de la partie flexible. Une branche 15 peut être reliée à la partie arquée de sorte à raccorder celle-ci à une portion de l'électrode correspondante située au niveau de la zone d'ancrage 12. En particulier, la branche 15 permet de relier la portion arquée à un plot 19 permettant une reprise de contact. Comme précédemment, il est avantageux, au moins pour l'électrode 5, de placer une majorité de sa superficie au niveau d'une zone de la partie flexible de l'élément déformable 2 présentant une forte concentration de contraintes. Comme précédemment, il est même souhaitable d'opérer cette localisation dans une zone présentant un pic (c'est-à-dire un maximum sur une courbe de concentration de contraintes). Le mode de réalisation des figures 7 et 8 présente un placement correspondant de l'électrode secondaire 7 de sorte que les deux empilements capacitifs sont situés à des zones où se produisent des maxima de concentration de contraintes.

On peut si besoin placer les électrodes 5 et 7 dans des zones de la partie flexible qui subissent des contraintes de signes opposés (l'une en traction de la fibre moyenne, l'autre en compression).

Dans ce mode de réalisation, l'électrode d'actionnement 6 s'étend de préférence suivant un diamètre de la membrane. Suivant cette direction, à partir d'un premier côté de la membrane, l'électrode 6 comporte une branche 17 puis une partie centrale 16 puis une autre branche 17 permettant d'atteindre un côté opposé de la membrane. Éventuellement, aux extrémités des branches 17, des plots 18 peuvent être formés. Avantageusement, la partie centrale 16 est un disque centré sur le profil circulaire de la membrane. Le diamètre de ce disque peut être compris entre un quart et la moitié de celui de la membrane.

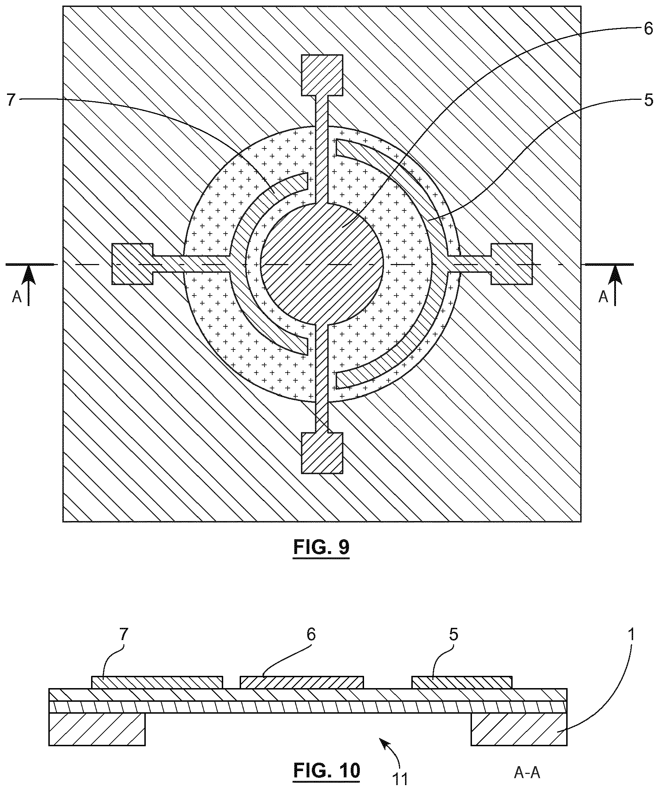

La **figure 9** présente une variante du mode de réalisation des figures 7 et 8 en ce que l'électrode secondaire 7 est positionnée toujours de manière à présenter une portion arquée concentrique avec le contour circulaire de la membrane de la partie flexible mais de manière plus proche du centre de ce contour circulaire. Plus précisément, il est avantageux que la portion arquée soit une portion d'arc de cercle dont le rayon correspond à la moitié du rayon du contour circulaire de la membrane. De cette façon, la portion arquée de l'électrode 7 se situe dans une zone présentant un minimum de concentration de contraintes. En effet, sur une telle membrane, les contraintes les plus élevées se trouvent à proximité de la zone d'ancrage 12 et au niveau du centre de la membrane. Dans une zone intermédiaire, un point d'inflexion est constaté et une concentration de contraintes minimum est produite à ce niveau. Ainsi, dans ce cas de figure, on peut opérer une mesure différentielle suivant le même principe que celui présenté en référence aux figures 5 et 6 avec des éléments déformables 2. En particulier, l'empilement capacitif secondaire formé à partir de l'électrode secondaire 7 produit de faibles variations de contraintes et de permittivité entre une position de repos et une position d'actionnement de l'élément déformable 2.

La **figure 10** présente une vue en coupe du mode de réalisation de la figure 9 illustrant la différenciation de positionnement des portions arquées respectivement des électrodes 5 et 7.

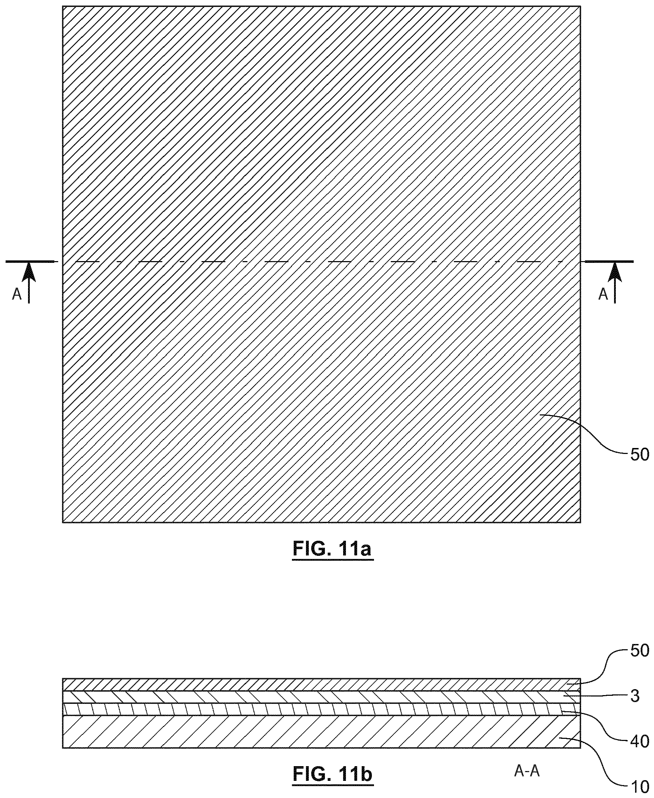

Les **figures 11a à 14b** montrent une succession d'étapes potentielles pour la fabrication d'un actionneur utilisable selon l'invention dans un mode de réalisation correspondant à celui des figures 7 et 8.

Les figures 11a et 11b présentent un empilement de couches réalisé sur une couche de support 10 (substrat) à partir de laquelle le support 1 est formé. Cet empilement comporte une couche 40 de formation de l'électrode de référence, une couche 3 formant la couche électro-active, et une couche 50 permettant de former la ou les électrodes de mesure et la ou les électrodes d'actionnement. La formation de cet empilement peut être opérée par des dépôts mettant en oeuvre des techniques classiques de microélectronique en particulier par pulvérisation ou évaporation.

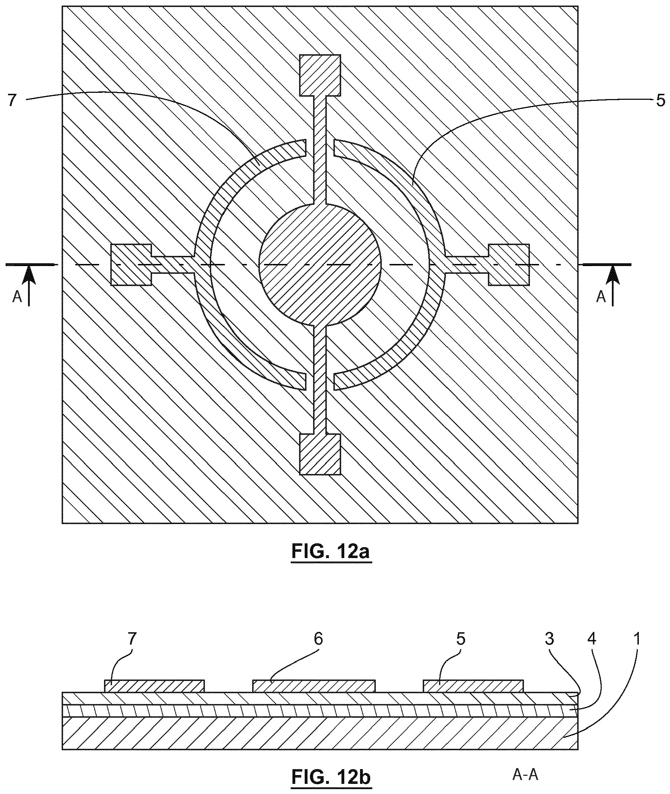

Les figures 12a et 12b présentent une étape suivante dans laquelle les électrodes d'actionnement 6 et de mesure 5, 7 sont formées à partir de la couche 50. À cet effet, un procédé lithographique peut être mis en oeuvre pour protéger les zones que l'on souhaite conserver et une gravure, chimique ou physique, peut permettre de retirer les zones non désirées, non recouvertes par le procédé lithographique. De manière classique, la résine utilisée pour la lithographie peut ensuite être retirée, par exemple chimiquement avec un solvant.

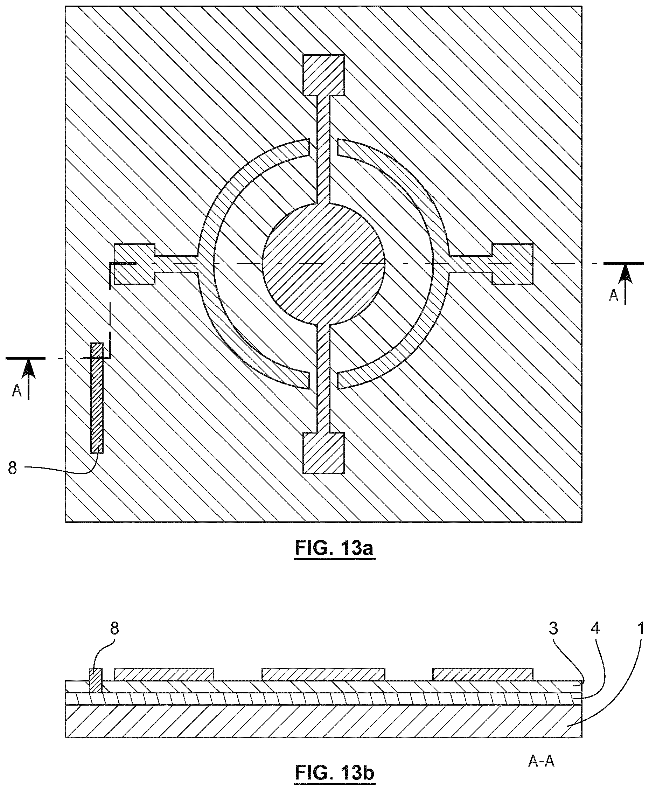

Les figures 13a et 13b présentent une autre étape du procédé de fabrication dans laquelle on réalise une reprise de contact pour l'électrode de référence 4. À cet effet, un organe de raccordement 8 est produit. Pour ce faire, on peut réaliser une ouverture dans une portion de la couche électro-active 3 non recouverte par une électrode 5, 6 ou 7 ; cette ouverture peut être réalisée comme précédemment avec un procédé lithographique suivi d'une gravure. En outre, avant de retirer la résine de lithographie, on pourra déposer un matériau conducteur, typiquement un métal, dans cette ouverture de sorte à produire l'organe de raccordement 8. Notamment, par un procédé « lift off », seul le métal déposé sur l'ouverture de la couche active sera conservé après le retrait de la résine. Ce dépôt peut faciliter la reprise de contact sur l'électrode de référence ultérieure. On notera que la couche électro-active 3 est typiquement suffisamment isolante électriquement pour ne pas nécessiter d'isolation de l'ouverture avant le dépôt de l'organe de raccordement 8.

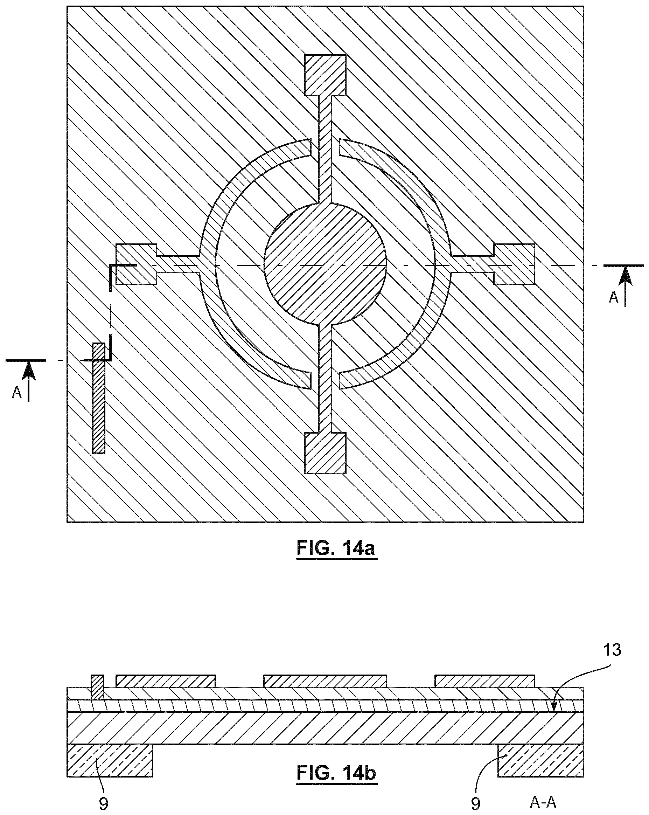

Les figures 14a et 14b présentent une autre étape par laquelle un masque 9 est formé sur une face du support 1 opposée à la face 13 par laquelle est opéré l'empilement des couches participant à l'élément déformable 2. Ce masque 9 est avantageusement un masque dur employé pour une photogravure ultérieure de la face arrière du support 1 en vue de réaliser la cavité 11. De préférence, la couche de masque 9 est un matériau choisi pour pouvoir être gravé sélectivement par rapport au support. Par exemple, si le support 1 est en silicium, le masque dur 9 peut être en dioxyde de silicium, qui peut se graver sélectivement par un plasma d'hexafluorure de soufre. Le masque 9, par exemple en dioxyde de silicium, peut-être notamment déposé par une technique de dépôt physico-chimique en phase vapeur assisté par plasma. Le masque dur est structuré par une étape lithographique puis par une gravure (notamment une gravure chimique à l'acide fluorhydrique). La résine de la lithographie est ensuite retirée par un solvant tel de l'acétone.

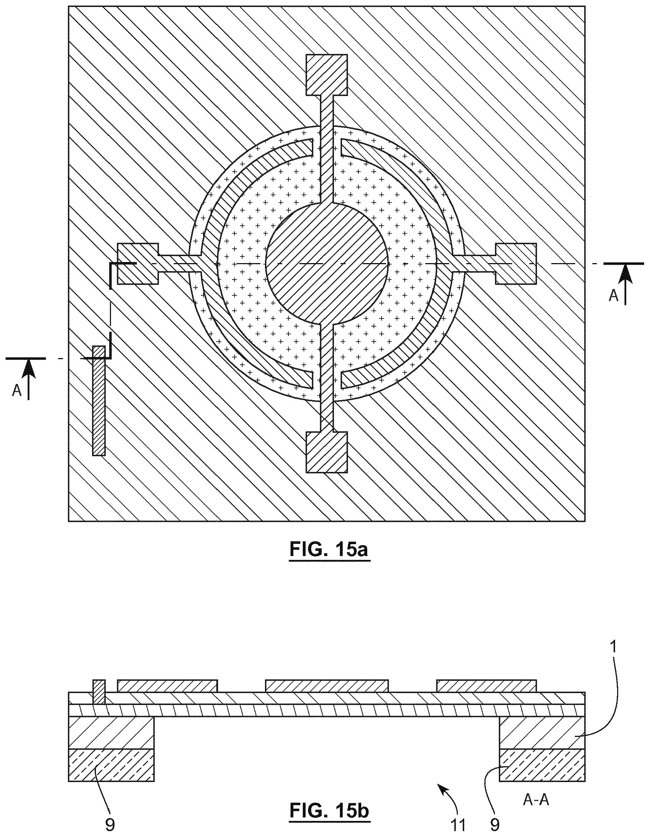

Une fois le masque 9 préparé, il est possible de réaliser la cavité 11. À cet effet, les figures 15a et 15b présentent une gravure du substrat depuis sa face arrière opposée à la face 13 en dehors du masque 9. On pourra par exemple utiliser une gravure ionique réactive, de préférence basée sur le procédé Bosch®.

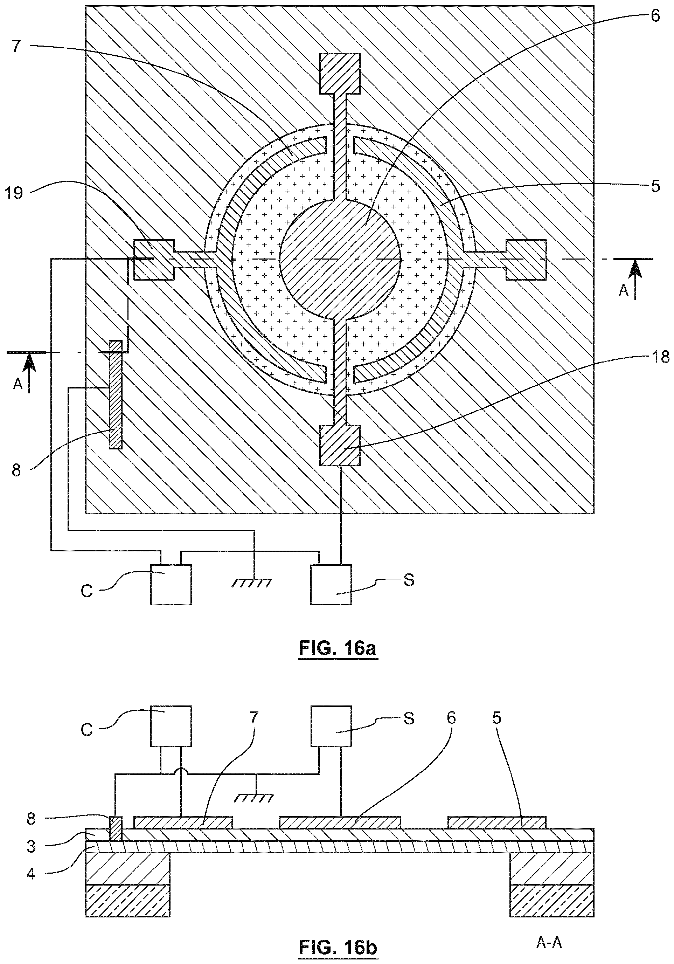

Les figures 16a et 16b présentent enfin le raccordement des électrodes avec une partie de commande et de traitement de signal de l'actionneur. Ce raccordement peut être opéré par des soudures au fil d'or. Comme représenté, on peut utiliser une source de tension S qui va permettre d'alimenter électriquement l'électrode d'actionnement 6 en contre-point de l'électrode de référence 4. Cette dernière est en outre raccordée à un potentiel de référence, par exemple la masse, de préférence via l'organe de raccordement 8. En ce qui concerne la mesure, un capacimètre C est raccordé à une électrode de mesure 5, ici au niveau d'un plot 19 de cette dernière. Une autre entrée du capacimètre est également placée au potentiel de référence tel que la masse et raccordée à l'électrode de référence.

On notera que la chronologie des étapes précédemment indiquées pour la réalisation de cet actionneur n'est qu'indicative ; en particulier, les étapes de formation de l'organe de raccordement 8 peuvent être opérées à d'autres moments.

Sauf indication spécifique du contraire, les caractéristiques techniques décrites en détail pour un mode de réalisation donné peuvent être combinées aux caractéristiques techniques décrites dans le contexte d'autres modes de réalisation décrits à titre exemplaire et non limitatif, dont ceux expliqués en détail ci-dessus. Par exemple, la forme de l'électrode de mesure 5 de la figure 3 peut être transposée aux modes de réalisation des figures 1, 2, 5 et 6. Il en est de même pour la forme de l'électrode d'actionnement 6. De même, la mesure différentielle peut être appliquée à tous les cas.

## Revendications

1. Actionneur électromécanique comportant un support (1) et un élément déformable (2) comprenant une partie ancrée à au moins une zone d'ancrage (12) du support (1) et une partie mobile, l'élément déformable (2) comprenant une couche électro-active (3), une électrode de référence (4) disposée sur une première face de la couche électro-active (3) et une électrode d'actionnement (6) disposée sur une deuxième face, opposée à la première face, de la couche électro-active (3), la couche électro-active (3) étant configurée pour se déformer sous l'effet d'une différence de potentiel appliquée entre l'électrode de référence (4) et l'électrode d'actionnement (6),
ledit actionneur comprenant :
- un dispositif capacitif de mesure de déformation de l'élément déformable (2), ledit dispositif étant au moins en partie formé par un empilement capacitif comprenant une électrode de mesure (5) sur la deuxième face de la couche électro-active (3), une partie de mesure de l'électrode de référence (4) située en regard de l'électrode de mesure (5), et une partie de la couche électro-active (3) intercalée entre l'électrode de mesure (5) et la partie de mesure de l'électrode de référence (4),
**caractérisé en ce que** le dispositif capacitif de mesure est configuré pour mesurer la capacité de l'empilement capacitif.

2. Actionneur selon la revendication précédente, dans lequel l'empilement capacitif est situé à proximité de la zone d'ancrage (12).

3. Actionneur selon l'une des revendications précédentes, dans lequel l'empilement capacitif est situé pour partie dans la partie ancrée et pour partie dans la partie mobile.

4. Actionneur selon l'une des revendications précédentes, dans lequel au moins une portion de l'empilement capacitif est située dans une zone de l'élément déformable (2) présentant un pic de concentration de contraintes en flexion.

5. Actionneur selon l'une des revendications précédentes, dans lequel la partie mobile comprend une poutre ou une membrane de profil circulaire, rectangulaire ou polygonale.

6. Actionneur selon la revendication précédente, dans lequel au moins une portion de l'électrode de mesure présente un profil parallèle au profil de la partie mobile.

7. Actionneur selon la revendication précédente dans lequel au moins une portion de l'électrode de mesure présente un profil arqué et au moins une partie de la portion de la partie mobile présente un profil circulaire ; lesdits profils étant de préférence parallèles.

8. Actionneur selon l'une des revendications précédentes, dans lequel le dispositif de mesure comprend un empilement capacitif secondaire comprenant une électrode secondaire de mesure (7) disposée sur la deuxième face de la couche électro-active (3), une partie secondaire de mesure de l'électrode de référence (4) située en regard de l'électrode secondaire de mesure (7), et une partie de la couche électro-active (3) intercalée entre l'électrode secondaire de mesure (7) et ladite partie secondaire de mesure de l'électrode de référence (4).

9. Actionneur selon la revendication précédente et la revendication 5 en combinaison, dans lequel au moins une portion de l'électrode secondaire de mesure (7) présente un profil parallèle au profil de la partie mobile.

10. Actionneur selon la revendication précédente, dans lequel la partie mobile comporte une membrane circulaire, le profil de la portion de l'électrode secondaire de mesure (7) étant arqué et situé à mi-rayon du profil circulaire de la membrane.

11. Actionneur selon l'une des trois revendications précédentes, dans lequel au moins une portion de l'empilement capacitif secondaire est située dans une zone de l'élément déformable (2) présentant un minimum de concentration de contraintes.

12. Actionneur selon l'une des revendications 8 à 10, dans lequel au moins une portion de l'empilement capacitif secondaire est située dans une zone de l'élément déformable (2) présentant une contrainte de signe opposé à celle de la zone dans laquelle est située au moins une portion de l'empilement capacitif.

13. Actionneur selon l'une des revendications 8 à 12, comprenant un dispositif de traitement différentiel des variations de valeur de capacité de l'empilement capacitif et de l'empilement capacitif secondaire.

14. Actionneur selon l'une des revendications précédentes, comprenant une source de tension (S) raccordée, par une première de ses bornes, à l'électrode d'actionnement (6), un capacimètre (C) raccordé, par une première de ses bornes, à l'électrode de mesure (5), les deuxièmes bornes de la source de tension et du capacimètre étant toutes deux raccordées à l'électrode de référence (4) et à un potentiel de référence.

15. Actionneur selon l'une des revendications précédentes, dans lequel la couche électro-active (3) comprend au moins une couche d'un matériau choisi parmi : un matériau piézoélectrique, un matériau électro-strictif, un matériau para-électrique ou un matériau relaxeur.

16. Actionneur selon l'une des revendications précédentes, dans lequel l'électrode de mesure (5) et l'électrode d'actionnement (6) sont des portions gravées d'une même couche de matériau.

17. Actionneur selon l'une des revendications précédentes, constitué par un composant microélectronique.

## Patentansprüche

1. Elektromechanisches Stellglied, enthaltend einen Träger (1) und ein verformbares Element (2), das ein an zumindest einem Verankerungsbereich (12) des Trägers (1) verankertes Teil und ein bewegliches Teil enthält, wobei das verformbare Element (2) eine elektroaktive Schicht (3), eine auf einer ersten Seite der elektroaktiven Schicht (3) angeordnete Bezugselektrode (4) und eine Betätigungselektrode (6) enthält, die auf einer der ersten Seite gegenüberliegenden zweiten Seite der elektroaktiven Schicht (3) angeordnet ist, wobei die elektroaktive Schicht (3) dazu ausgelegt ist, sich unter der Wirkung einer zwischen der Bezugselektrode (4) und der Betätigungselektrode (6) angelegten Potentialdifferenz zu verformen,
wobei das Stellglied enthält:
- eine kapazitive Messvorrichtung zum Messen der Verformung des verformbaren Elements (2), wobei die Vorrichtung zumindest teilweise aus einer kapazitiven Stapelung gebildet ist, die eine Messelektrode (5) auf der zweiten Seite der elektroaktiven Schicht (3), ein der Messelektrode (5) gegenüberliegendes Messteil der Bezugselektrode (4) und ein zwischen der Messelektrode (5) und dem Messteil der Bezugselektrode (4) eingefügtes Teil der elektroaktiven Schicht (3) enthält, **dadurch gekennzeichnet, dass** die kapazitive Messvorrichtung dazu ausgelegt ist, die Kapazität der kapazitiven Stapelung zu messen.

2. Stellglied nach dem vorangehenden Anspruch, wobei die kapazitive Stapelung in der Nähe des Verankerungsbereichs (12) liegt.

3. Stellglied nach einem der vorangehenden Ansprüche, wobei die kapazitive Stapelung teilweise in dem verankerten Teil und teilweise in dem beweglichen Teil liegt.

4. Stellglied nach einem der vorangehenden Ansprüche, wobei zumindest ein Abschnitt der kapazitiven Stapelung in einem Bereich des verformbaren Elements (2) liegt, der eine Spitze der Biegespannungskonzentration aufweist.

5. Stellglied nach einem der vorangehenden Ansprüche, wobei das bewegliche Teil eine Stütze oder Membran mit kreisförmigem, rechteckigem oder polygonalem Profil enthält.

6. Stellglied nach dem vorangehenden Anspruch, wobei zumindest ein Abschnitt der Messelektrode ein zum Profil des beweglichen Teils parallel verlaufendes Profil aufweist.

7. Stellglied nach dem vorangehenden Anspruch, wobei zumindest ein Abschnitt der Messelektrode ein bogenförmiges Profil aufweist und zumindest ein Teil des Abschnitts des beweglichen Teils ein kreisförmiges Profil aufweist; wobei die Profile vorzugsweise parallel verlaufen.

8. Stellglied nach einem der vorangehenden Ansprüche, wobei die Messvorrichtung eine kapazitive Sekundärstapelung enthält, die eine auf der zweiten Seite der elektroaktiven Schicht (3) angeordnete Sekundärmesselektrode (7), ein der Sekundärmesselektrode (7) gegenüberliegendes Sekundärmessteil der Bezugselektrode (4) und ein zwischen der Sekundärmesselektrode (7) und dem Sekundärmessteil der Bezugselektrode (4) eingefügtes Teil der elektroaktiven Schicht (3) enthält.

9. Stellglied nach dem vorangehenden Anspruch in Kombination mit Anspruch 5, wobei zumindest ein Abschnitt der Sekundärmesselektrode (7) ein zum Profil des beweglichen Teils parallel verlaufendes Profil aufweist.

10. Stellglied nach dem vorangehenden Anspruch, wobei das bewegliche Teil eine kreisförmige Membran enthält, wobei das Profil des Abschnitts der Sekundärmesselektrode (7) bogenförmig ist und auf halbem Radius des kreisförmigen Profils der Membran liegt.

11. Stellglied nach einem der drei vorangehenden Ansprüche, wobei zumindest ein Abschnitt der kapazitiven Sekundärstapelung in einem Bereich des verformbaren Elements (2) liegt, der ein Minimum an Beanspruchungsspannungskonzentration aufweist.

12. Stellglied nach einem der Ansprüche 8 bis 10, wobei zumindest ein Abschnitt der kapazitiven Sekundärstapelung in einem Bereich des verformbaren Elements (2) liegt, der eine Beanspruchungsspannung mit entgegengesetztem Vorzeichen zu dem des Bereichs aufweist, in welchem zumindest ein Abschnitt der kapazitiven Stapelung liegt.

13. Stellglied nach einem der Ansprüche 8 bis 12, enthaltend eine Vorrichtung zum differentiellen Verarbeiten von Änderungen des Kapazitätswerts der kapazitiven Stapelung und der kapazitiven Sekundärstapelung.

14. Stellglied nach einem der vorangehenden Ansprüche, enthaltend eine Spannungsquelle (S), die mit einem ersten ihrer Anschlüsse an die Betätigungselektrode (6) angeschlossen ist, einen Kapazitätsmesser (C), der mit einem ersten seiner Anschlüsse an die Messelektrode (5) angeschlossen ist, wobei die zweiten Anschlüsse von Spannungsquelle und Kapazitätsmesser beide an die Bezugselektrode (4) und an ein Bezugspotential angeschlossen sind.

15. Stellglied nach einem der vorangehenden Ansprüche, wobei die elektroaktive Schicht (3) zumindest eine Schicht aus einem Material, ausgewählt aus einem piezoelektrischen Material, einem elektrostriktiven Material, einem paraelektrischen Material oder einem Relaxormaterial, enthält.

16. Stellglied nach einem der vorangehenden Ansprüche, wobei die Messelektrode (5) und die Betätigungselektrode (6) aus derselben Materialschicht geätzte Abschnitte sind.

17. Stellglied nach einem der vorangehenden Ansprüche, bestehend aus einem mikroelektronischen Bauteil.

## Claims

1. Electromechanical actuator comprising a support (1) and a deformable element (2) comprising a part anchored to at least one anchoring zone (12) of the support (1) and a mobile part, the deformable element (2) comprising an electroactive layer (3), a reference electrode (4) arranged on a first face of the electroactive layer (3) and an actuation electrode (6) arranged on a second face, opposite the first face, of the electroactive layer (3), the electroactive layer (3) being configured to be deformed under the effect of a potential difference applied between the reference electrode (4) and the actuation electrode (6),
said actuator comprising:
- a capacitive device for measuring deformation of the deformable element (2), said device being at least partially formed by a capacitive stack comprising a measuring electrode (5) on the second face of the electroactive layer (3), a part for measuring the reference electrode (4) situated facing the measuring electrode (5), and a part of the electroactive layer (3) inserted between the measuring electrode (5) and the part for measuring the reference electrode (4), **characterised in that** the measuring capacitive device is configured to measure the capacity of the capacitive stack.

2. Actuator according to the preceding claim, wherein the capacitive stack is situated in the proximity of the anchoring zone (12).

3. Actuator according to one of the preceding claims, wherein the capacitive stack is situated partially in the anchored part and partially in the mobile part.

4. Actuator according to one of the preceding claims, where at least one portion of the capacitive stack is situated in a zone of the deformable element (2) having a bend stress concentration peak.

5. Actuator according to one of the preceding claims, wherein the mobile part comprises a beam or a circular, rectangular or polygonal profile membrane.

6. Actuator according to the preceding claim, wherein at least one portion of the measuring electrode has a profile parallel to the profile of the mobile part.

7. Actuator according to the preceding claim, wherein at least one portion of the measuring electrode has an arched profile and at least one part of the portion of the mobile part has a circular profile; said profiles preferably being parallel.

8. Actuator according to one of the preceding claims, wherein the measuring device comprises a secondary capacitive stack comprising a secondary measuring electrode (7) arranged on the second face of the electroactive layer (3), a secondary measuring part of the reference electrode (4) situated facing the secondary measuring electrode (7), and a part of the electroactive layer (3) inserted between the secondary measuring electrode (7) and said secondary measuring part of the reference electrode (4).

9. Actuator according to the preceding claim and claim 5 in combination, wherein at least one portion of the secondary measuring electrode (7) has a profile parallel to the profile of the mobile part.

10. Actuator according to the preceding claim, wherein the mobile part comprises a circular membrane, the profile of the portion of the secondary measuring electrode (7) being arched and situated at mid-radius of the circular profile of the membrane.

11. Actuator according to one of the three preceding claims, wherein at least one portion of the secondary capacitive stack is situated in a zone of the deformable element (2) having a minimum stress concentration.

12. Actuator according to one of claims 8 to 10, wherein at least one portion of the secondary capacitive stack is situated in a zone of the deformable element (2) having a sign stress opposite that of the zone wherein is situated at least one portion of the capacitive stack.

13. Actuator according to one of claims 8 to 12, comprising a device for differentially processing variation of capacity value of the capacitive stack and of the secondary capacitive stack.

14. Actuator according to one of the preceding claims, comprising a voltage source (S) connected, by a first of the terminals thereof, to the actuation electrode (6), a capacitymeter (C) connected, by a first of the terminals thereof, to the measuring electrode (5), the second terminals of the voltage source and of the capacity meter both being connected to the reference electrode (4) and to a reference potential.

15. Actuator according to one of the preceding claims, wherein the electroactive layer (3) comprises at least one layer of a material selected from among: a piezoelectric material, an electrostrictive material, a paraelectric material or a relaxor material.

16. Actuator according to one of the preceding claims, wherein the measuring electrode (5) and the actuation electrode (6) are portions engraved from one same layer of material.

17. Actuator according to one of the preceding claims, constituted by a microelectronic component.
